# EUROPEAN PATENT APPLICATION

(11) **EP 4 592 988 A1**
(43) Date of publication of application: **30.07.2025**
(21) Application number: 24223653.7
(22) Date of filing: 30.12.2024
(51) Int. Cl.: G08G 5/20

(54) **SYSTEMS, APPARATUSES, METHODS, AND COMPUTER PROGRAM PRODUCTS FOR INITIATING PERFORMANCE OF ONE OR MORE INCIDENT RESPONSE ACTIONS**

(30) Priority: 24.01.2024 US 202463624589 P; 10.09.2024 US 202418830022
(71) Applicant: Honeywell International Inc., Charlotte, NC 28202 (US)
(72) Inventor: GROPPENBACHER, David, Charlotte, 28202 (US); FINSETH, Tor, Charlotte, 28202 (US); DE MERS, Robert, Charlotte, 28202 (US)
(74) Representative: Haseltine Lake Kempner LLP

(57) **Abstract**

Systems, apparatuses, methods, and computer program products are provided herein. For example, a method includes identifying vehicle data from one or more data sources. In some embodiments, the method may include generating, based at least in part on applying the vehicle data to a vehicle aggregation and identification model, optimized vehicle data. In some embodiments, the method may include generating, based at least in part on applying geolocation and connection data to a vehicle geolocation and connection model, vehicle geolocation and connection enablement data. In some embodiments, the method may include generating, based at least in part on applying the optimized vehicle data and the vehicle geolocation and connection enablement data to a vehicle prioritization model, a prioritized vehicle data package. In some embodiments, the method may include initiating performance of one or more primary incident response actions based at least in part on the prioritized vehicle data package.

## Description

### CROSS REFERENCE TO RELATED APPLICATIONS

This application claims the benefit of U.S. Provisional Application No. 63/624,589 filed January 24, 2024, and entitled "Systems, Apparatuses, Methods, And Computer Program Products for Initiating Performance of One or More Incident Response Actions," which is hereby incorporated by reference in its entirety.

### FIELD

Embodiments of the present disclosure relate generally to systems, apparatuses, methods, and computer program products for initiating performance of one or more incident response actions.

### BACKGROUND

Applicant has identified many technical challenges and difficulties associated with systems, apparatuses, methods, and computer program products for initiating performance of one or more incident response actions. Through applied effort, ingenuity, and innovation, Applicant has solved problems related to systems, apparatuses, methods, and computer program products for initiating performance of one or more incident response actions by developing solutions embodied in the present disclosure, which are described in detail below.

### BRIEF SUMMARY

Various embodiments described herein relate to systems, apparatuses, methods, and computer program products for initiating performance of one or more incident response actions.

In accordance with one aspect of the disclosure, a method is provided. In some embodiments, the method may include identifying vehicle data from one or more data sources. In accordance with one aspect of the disclosure, a method is provided. In some embodiments, the method may include generating, based at least in part on applying the vehicle data to a vehicle aggregation and identification model, optimized vehicle data. In accordance with one aspect of the disclosure, a method is provided. In some embodiments, the method may include generating, based at least in part on applying geolocation and connection data to a vehicle geolocation and connection model, vehicle geolocation and connection enablement data. In accordance with one aspect of the disclosure, a method is provided. In some embodiments, the method may include generating, based at least in part on applying the optimized vehicle data and the vehicle geolocation and connection enablement data to a vehicle prioritization model, a prioritized vehicle data package. In accordance with one aspect of the disclosure, a method is provided. In some embodiments, the method may include initiating performance of one or more primary incident response actions based at least in part on the prioritized vehicle data package.

In some embodiments, the vehicle data comprises vehicle external data, vehicle occupant data, time clock data, and vehicle operations data.

In some embodiments, the one or more data sources comprises a vehicle external data source, an occupant data source, a vehicle time clock data source, and a vehicle operations data source.

In some embodiments, identifying the vehicle data comprises extracting at least a portion of the vehicle data from one or more of a vehicle control apparatus, a vehicle avionics apparatus, or a vehicle communications apparatus.

In some embodiments, the method may include generating, based at least in part on applying unprocessed audio data to a vehicle audio processing model, vehicle audio data.

In some embodiments, applying the unprocessed audio data to the vehicle audio processing model comprises performing at least one voice analysis task or at least one recognition task.

In some embodiments, generating the prioritized vehicle data package further comprises applying the vehicle audio data to the vehicle prioritization model.

In some embodiments, the method may include generating, based at least in part on applying the optimized vehicle data and the vehicle geolocation and connection enablement data to the vehicle prioritization model, a secondary vehicle data package.

In some embodiments, the method may include initiating performance of one or more secondary incident response actions based at least in part on the secondary vehicle data package.

In some embodiments, the one or more primary incident response actions are initiated when a vehicle associated with the prioritized vehicle data package is in flight and the one or more secondary incident response actions are initiated when the vehicle associated with the prioritized vehicle data package is on the ground.

In accordance with another aspect of the disclosure, an apparatus is provided. In some embodiments, the apparatus may include at least one processor and at least one non-transitory memory including computer-coded instructions thereon. In some embodiments, the at least one non-transitory memory and the computer-coded instructions are configured to, with the at least one processor, cause the apparatus to at least identify vehicle data from one or more data sources. In some embodiments, the at least one non-transitory memory and the computer-coded instructions are configured to, with the at least one processor, cause the apparatus to at least generate, based at least in part on applying the vehicle data to a vehicle aggregation and identification model, optimized vehicle data. In some embodiments, the at least one non-transitory memory and the computer-coded instructions are configured to, with the at least one processor, cause the apparatus to at least generate, based at least in part on applying geolocation and connection data to a vehicle geolocation and connection model, vehicle geolocation and connection enablement data. In some embodiments, the at least one non-transitory memory and the computer-coded instructions are configured to, with the at least one processor, cause the apparatus to at least generate, based at least in part on applying the optimized vehicle data and the vehicle geolocation and connection enablement data to a vehicle prioritization model, a prioritized vehicle data package. In some embodiments, the at least one non-transitory memory and the computer-coded instructions are configured to, with the at least one processor, cause the apparatus to at least initiate performance of one or more primary incident response actions based at least in part on the prioritized vehicle data package.

In some embodiments, the vehicle data comprises vehicle external data, vehicle occupant data, time clock data, and vehicle operations data.

In some embodiments, to identify the vehicle data comprises the at least one non-transitory memory and the program code being configured to, with the at least one processor, further cause the apparatus to at least extract at least a portion of the vehicle data from one or more of a vehicle control apparatus, a vehicle avionics apparatus, or a vehicle communications apparatus.

In some embodiments, the at least one non-transitory memory and the computer-coded instructions are configured to, with the at least one processor, cause the apparatus to generate, based at least in part on applying unprocessed audio data to a vehicle audio processing model, vehicle audio data.

In some embodiments, to apply the unprocessed audio data to the vehicle audio processing model comprises the at least one non-transitory memory and the program code being configured to, with the at least one processor, further cause the apparatus to at least perform at least one voice analysis task or at least one recognition task.

In some embodiments, to generate the prioritized vehicle data package further comprises the at least one non-transitory memory and the program code being configured to, with the at least one processor, further cause the apparatus to at least apply the vehicle audio data to the vehicle prioritization model.

In some embodiments, the at least one non-transitory memory and the computer-coded instructions are configured to, with the at least one processor, cause the apparatus to generate, based at least in part on applying the optimized vehicle data and the vehicle geolocation and connection enablement data to the vehicle prioritization model, a secondary vehicle data package.

In some embodiments, the at least one non-transitory memory and the computer-coded instructions are configured to, with the at least one processor, cause the apparatus to initiate performance of one or more secondary incident response actions based at least in part on the secondary vehicle data package.

In some embodiments, the one or more primary incident response actions are initiated when a vehicle associated with the prioritized vehicle data package is in flight and the one or more secondary incident response actions are initiated when the vehicle associated with the prioritized vehicle data package is on the ground.

In accordance with another aspect of the disclosure, a computer program product is provided. In some embodiments, the computer program product includes at least one non-transitory computer-readable storage medium having computer program code stored thereon. In some embodiments, the computer program code, in execution with at least one processor, configures the computer program product to identify vehicle data from one or more data sources. In some embodiments, the computer program code, in execution with at least one processor, configures the computer program product to generate, based at least in part on applying the vehicle data to a vehicle aggregation and identification model, optimized vehicle data. In some embodiments, the computer program code, in execution with at least one processor, configures the computer program product to generate, based at least in part on applying geolocation and connection data to a vehicle geolocation and connection model, vehicle geolocation and connection enablement data. In some embodiments, the computer program code, in execution with at least one processor, configures the computer program product to generate, based at least in part on applying the optimized vehicle data and the vehicle geolocation and connection enablement data to a vehicle prioritization model, a prioritized vehicle data package. In some embodiments, the computer program code, in execution with at least one processor, configures the computer program product to initiate performance of one or more primary incident response actions based at least in part on the prioritized vehicle data package.

The above summary is provided merely for purposes of summarizing some example embodiments to provide a basic understanding of some aspects of the present disclosure. Accordingly, it will be appreciated that the above-described embodiments are merely examples and should not be construed to narrow the scope or spirit of the disclosure in any way. It will be appreciated that the scope of the present disclosure encompasses many potential embodiments in addition to those here summarized, some of which will be further described below.

### BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.
FIG. 1 illustrates an exemplary block diagram of an environment in which embodiments of the present disclosure may operate;
FIG. 2 illustrates an exemplary block diagram of an example apparatus that may be specially configured in accordance with an example embodiment of the present disclosure;
FIG. 3 illustrates an example visualization of a vehicle incident operational system in accordance with one or more embodiments of the present disclosure; and
FIG. 4 illustrates a flowchart of an example method in accordance with one or more embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

### Definitions

The phrases "in one embodiment," "according to one embodiment," "for example," "in some examples," "as an example," and the like generally mean that the particular feature, structure, or characteristic following the phrase may be included in at least one embodiment of the present disclosure, and may be included in more than one embodiment of the present disclosure (such phrases do not necessarily refer to the same embodiment).

The word "example" or "exemplary" is used herein to mean "serving as an example, instance, or illustration." Any implementation described herein as "example" or "exemplary" is not necessarily to be construed as preferred or advantageous over other implementations.

If the specification states a component or feature "may," "can," "could," "should," "would," "preferably," "possibly," "typically," "optionally," "for example," "in some examples," "often," or "might" (or other such language) be included or have a characteristic, that a specific component or feature is not required to be included or to have the characteristic. Such component or feature may be optionally included in some embodiments, or it may be excluded.

The term "circuitry" should be understood broadly to include hardware and, in some embodiments, software for configuring the hardware. With respect to components of the apparatus, the term "circuitry" as used herein should therefore be understood to include particular hardware configured to perform the functions associated with the particular circuitry as described herein. For example, in some embodiments, "circuitry" may include processing circuitry, storage media, network interfaces, input/output devices, and the like.

The term "electronically coupled," "electronically coupling," "electronically couple," "in communication with," "in electronic communication with," or "connected" in the present disclosure refers to two or more components (for example but not limited to, client device(s), a data analytics system, database(s)) being connected through wired means (for example but not limited to, wired Ethernet) and/or wireless means (for example but not limited to, Wi-Fi, Bluetooth, ZigBee), such that data and/or information may be transmitted to and/or received from these components.

The term "vehicle" may be used to describe any machine, robot, computing devices, and/or apparatus comprised of hardware, software, firmware, and/or any combination thereof, that maneuvers throughout an environment through any medium. In some contexts, a vehicle is utilized to transport objects, entities (e.g., people, animals, or other beings), or other onboard cargo. In some situations, a vehicle may be transporting no object except for the vehicle itself. Vehicles may be used for transportation on land, in water, in air, or across any other medium. Examples of vehicles include airplanes, helicopters, drones, cars, trucks, submarines, boats, and/or the like. Vehicles are not limited to the examples listed herein and may include any type of transportation device.

### Overview

Example embodiments disclosed herein address technical problems associated with systems, apparatuses, methods, and computer program products for initiating performance of one or more incident response actions. As would be understood by one skilled in the field to which this disclosure pertains, there are numerous example scenarios in which a user may use systems, apparatuses, methods, and computer program products for initiating performance of one or more incident response actions.

In many applications, initiating performance of one or more incident response actions is desirable when responding to an incident (e.g., a car accident, a plane crash, and/or a boat accident). In some implementations, it may be desirable for a vehicle incident operational system of a vehicle to initiate performance of one or more incident response actions when responding to an incident. For example, it may be desirable for a vehicle incident operational system of a medical transportation rotary wing air vehicle (e.g., a vehicle) to initiate performance of one or more incident response actions while transporting an individual from an incident site to a hospital (e.g., when responding to an incident).

Example solutions for initiating performance of one or more incident response actions are inefficient, are unable to consider relevant data, and are resource intensive. For example, example solutions for initiating performance of one or more incident response actions are inefficient because such example solutions are unable to initiate performance of one or more incident response actions in real-time (e.g., when in flight). As a result, such example solutions must wait until the vehicle has arrived at an asset to initiate performance of one or more incident response actions. As another example, example solutions for initiating performance of one or more incident response actions are unable to consider relevant data because such example solutions are unable to consider geolocation and connection strength of a vehicle. As a result, such example solutions are unable to prioritize particular incident response actions to initiate performance of when responding to an incident. As another example, example solutions for initiating performance of one or more incident response actions are resource intensive because such example solutions are unable to generate audio data associated with a vehicle and integrate the audio data with other vehicle sensor data and external data while the vehicle is operating. As a result, such example solutions are unable to generate a comprehensive synopsis of an incident.

Thus, to address these and/or other issues related to systems, apparatuses, methods, and computer program products for initiating performance of one or more incident response actions, example systems, apparatuses, methods, and computer program product for initiating performance of one or more incident response actions are disclosed herein. For example, an embodiment in this disclosure, described in greater detail below, includes a method that includes generating, based at least in part on applying the vehicle data to a vehicle aggregation and identification model, optimized vehicle data. In some embodiments, the method may include generating, based at least in part on applying geolocation and connection data to a vehicle geolocation and connection model, vehicle geolocation and connection enablement data. In some embodiments, the method may include generating, based at least in part on applying the optimized vehicle data and the vehicle geolocation and connection enablement data to a vehicle prioritization model, a prioritized vehicle data package. In some embodiments, the method may include initiating performance of one or more primary incident response actions based at least in part on the prioritized vehicle data package. Accordingly, the systems, apparatuses, computer program products, and/or methods disclosed herein enable initiating performance of one or more incident response actions in an efficient and accurate manner with low resource consumption.

### Example Systems and Apparatuses

Embodiments of the present disclosure herein include systems, apparatuses, methods, and computer program products configured for initiating performance of one or more incident response actions. It should be readily appreciated that the embodiments of the apparatus, systems, methods, and computer program product described herein may be configured in various additional and alternative manners in addition to those expressly described herein.

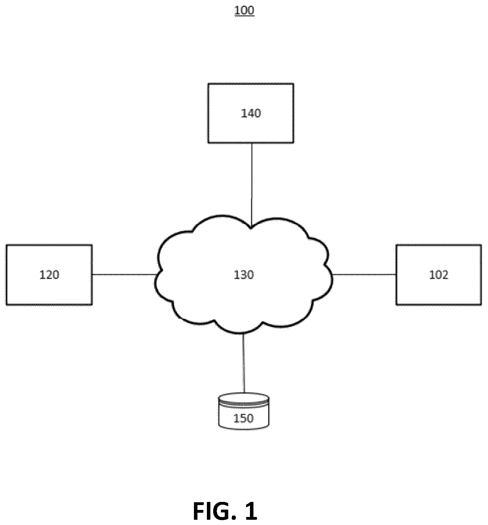

FIG. 1 illustrates an exemplary block diagram of an environment 100 in which embodiments of the present disclosure may operate. Specifically, FIG. 1 illustrates an asset 102. In some embodiments, for example, the asset 102 may be any type of location associated with initiating performance of one or more incident response actions. In this regard, the asset 102 may, for example, be a hospital, a geographic location, an incident response center, a preliminary response center, and/or the like. Although FIG. 1 depicts the environment 100 as including one asset 102, it would be understood by one skilled in the field to which this disclosure pertains that the environment may include more than one asset 102. For example, the environment 100 may include three assets.

In some embodiments, the environment 100 may include an incident site 120. In some embodiments, for example, the incident site 120 may be any type of location associated with initiating performance of one or more incident response actions. In this regard, the incident site 120 may, for example, be a location associated with an incident. For example, the incident site 120 may be a location where an individual has been injured (e.g., a car accident, a plane crash, and/or a boat accident). As another example, the incident site 120 may be a location in which an individual is awaiting transfer (e.g., a location sperate from where the individual was injured where a medical helicopter picks. As another example, the incident site 120 may be a location associated with a search and rescue operation (e.g., an area in which a search and rescue is being conducted, an area in which a search and rescue operation is being coordinated, etc.). Although FIG. 1 depicts the environment 100 as including one incident site 120, it would be understood by one skilled in the field to which this disclosure pertains that the environment may include more than one incident site 120. For example, the environment 100 may include three incident sites.

In some embodiments, the environment 100 may include a vehicle 140. In some embodiments the vehicle 140 embodies an air travel vehicle (e.g., a plane, an unmanned aerial vehicle, a medical air vehicle, and/or the like), a ground travel vehicle (e.g., a car or other automobile, an autonomous ground vehicle, an ambulance, and/or the like), and/or a water travel vehicle (e.g., a boat, a seaplane, a submersible vehicle, and/or the like).

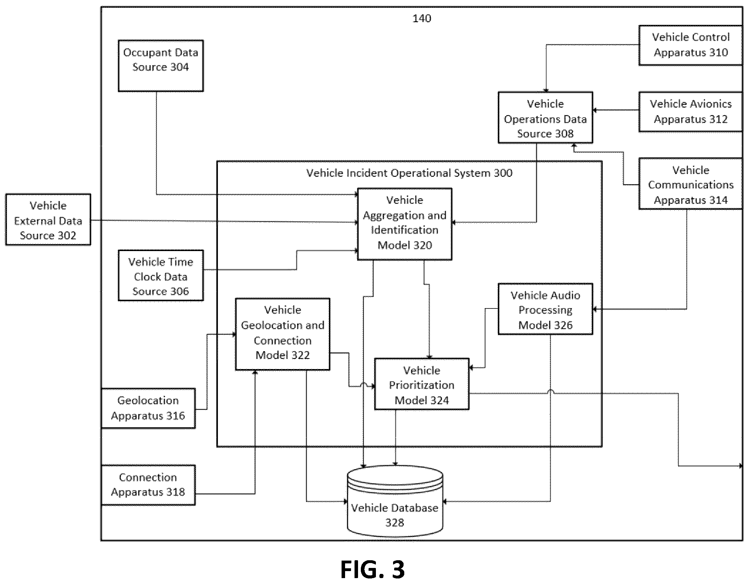

In some embodiments, such as illustrated in FIG. 3, the vehicle 140 may include a vehicle incident operational system 300. In some embodiments, for example, the vehicle incident operational system 300 may be configured to at least in part initiate performance of one or more incident response actions. The vehicle incident operational system 300 may be electronically and/or communicatively coupled to the asset 102, the incident site 120, individual components of the asset 102, and/or one or more databases 150. The vehicle incident operational system 300 may be located remotely, in proximity of, and/or within vehicle 140. For example, the vehicle incident operational system 300 may be an onboard component of the vehicle 140. As another example, the vehicle incident operational system 300 may be a cloud-based computing device located remotely from the vehicle 140. In some embodiments, the vehicle incident operational system 300 may be in communication with the asset 102, the incident site 120, individual components of the asset 102, and/or one or more databases 150 via the network 130.

In some embodiments, the vehicle incident operational system 300 is configured via hardware, software, firmware, and/or a combination thereof, to perform data intake of one or more types of data associated with initiating performance of one or more incident response actions. Additionally, or alternatively, in some embodiments, the vehicle incident operational system 300 is configured via hardware, software, firmware, and/or a combination thereof, to generate and/or transmit command(s) associated with initiating performance of one or more incident response actions. Additionally, or alternatively still, in some embodiments, the vehicle incident operational system 300 is configured via hardware, software, firmware, and/or a combination thereof, to perform data reporting and/or other data output process(es) associated with initiating performance of one or more incident response actions. For example, in various embodiments, the vehicle incident operational system 300 may be configured to execute and/or perform one or more operations and/or functions described herein. Additionally, or alternatively, in some embodiments, the vehicle incident operational system 300 is configured via hardware, software, firmware, and/or a combination thereof, to perform data storage (e.g., data storage of data associated with initiating performance of one or more incident response actions).

The one or more databases 150 may be configured to receive, store, and/or transmit data. In some embodiments, the one or more databases 150 may be associated with vehicle data, vehicle external data, vehicle occupant data, time clock data, vehicle operations data, optimized vehicle data, geolocation and connection data, vehicle geolocation and connection enablement data, a prioritized vehicle data package, a vehicle external data source, an occupant data source, a vehicle time clock data source, a vehicle operations data source, unprocessed audio data, vehicle audio data, and/or a secondary vehicle data package.

In some embodiments, the vehicle data, vehicle external data, vehicle occupant data, time clock data, vehicle operations data, optimized vehicle data, geolocation and connection data, vehicle geolocation and connection enablement data, a prioritized vehicle data package, a vehicle external data source, an occupant data source, a vehicle time clock data source, a vehicle operations data source, unprocessed audio data, vehicle audio data, and/or a secondary vehicle data package may be received from the vehicle 140, the incident site 120, the asset 102, and/or the vehicle incident operational system 300 by the one or more databases 150. In this regard, for example, the vehicle 140, the incident site 120, the asset 102, and/or the vehicle incident operational system 300 may be configured to generate, capture (e.g., using one or more sensors), and/or transmit vehicle data, vehicle external data, vehicle occupant data, time clock data, vehicle operations data, optimized vehicle data, geolocation and connection data, vehicle geolocation and connection enablement data, a prioritized vehicle data package, a vehicle external data source, an occupant data source, a vehicle time clock data source, a vehicle operations data source, unprocessed audio data, vehicle audio data, and/or a secondary vehicle data package.

The network 130 may be embodied in any of a myriad of network configurations. In some embodiments, the network 130 may be a public network (e.g., the Internet). In some embodiments, the network 130 may be a private network (e.g., an internal localized, or closed-off network between particular devices). In some other embodiments, the network 130 may be a hybrid network (e.g., a network enabling internal communications between particular connected devices and external communications with other devices). In various embodiments, the network 130 may include one or more base station(s), relay(s), router(s), switch(es), cell tower(s), communications cable(s), routing station(s), and/or the like. In various embodiments, components of the environment 100 may be communicatively coupled to transmit data to and/or receive data from one another over the network 130. Such configuration(s) include, without limitation, a wired or wireless Personal Area Network (PAN), Local Area Network (LAN), Metropolitan Area Network (MAN), Wide Area Network (WAN), and/or the like.

Additionally, while FIG. 1 illustrates certain components as separate, standalone entities communicating over the network 130, various embodiments are not limited to this configuration. In other embodiments, one or more components may be directly connected and/or share hardware or the like.

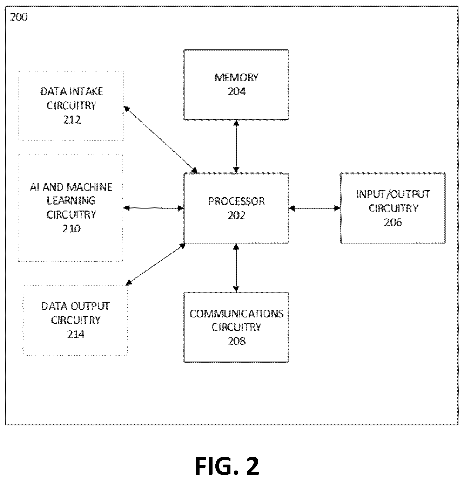

FIG. 2 illustrates an exemplary block diagram of an example apparatus that may be specially configured in accordance with an example embodiment of the present disclosure. Specifically, FIG. 2 depicts an example computing apparatus 200 ("apparatus 200") specially configured in accordance with at least some example embodiments of the present disclosure. For example, the computing apparatus 200 may be embodied as one or more of a specifically configured personal computing apparatus, a specifically configured cloud-based computing apparatus, a specifically configured embedded computing device (e.g., configured for edge computing, and/or the like). Examples of an apparatus 200 may include, but is not limited to, the vehicle incident operational system 300. The apparatus 200 includes processor 202, memory 204, input/output circuitry 206, communications circuitry 208, and/or artificial intelligence ("AI") and machine learning circuitry 210. In some embodiments, the apparatus 200 is configured to execute and perform the operations described herein.

Although components are described with respect to functional limitations, it should be understood that the particular implementations necessarily include the use of particular computing hardware. It should also be understood that in some embodiments certain of the components described herein include similar or common hardware. For example, in some embodiments two sets of circuitry both leverage use of the same processor(s), memory(ies), circuitry(ies), and/or the like to perform their associated functions such that duplicate hardware is not required for each set of circuitry.

In various embodiments, such as computing apparatus 200 of the vehicle incident operational system 300 may refer to, for example, one or more computers, computing entities, desktop computers, mobile phones, tablets, phablets, notebooks, laptops, distributed systems, servers, wearable devices, headphones, headsets, smart watches, cameras, image capture devices, or the like, and/or any combination of devices or entities adapted to perform the functions, operations, and/or processes described herein. Such functions, operations, and/or processes may include, for example, transmitting, receiving, operating on, processing, displaying, storing, determining, creating/generating, monitoring, evaluating, comparing, and/or similar terms used herein. In one embodiment, these functions, operations, and/or processes can be performed on data, content, information, and/or similar terms used herein. In this regard, the apparatus 200 embodies a particular, specially configured computing entity transformed to enable the specific operations described herein and provide the specific advantages associated therewith, as described herein.

Processor 202 or processor circuity 202 may be embodied in a number of different ways. In various embodiments, the use of the terms "processor" should be understood to include a single core processor, a multi-core processor, multiple processors internal to the apparatus 200, and/or one or more remote or "cloud" processor(s) external to the apparatus 200. In some example embodiments, processor 202 may include one or more processing devices configured to perform independently. Alternatively, or additionally, processor 202 may include one or more processor(s) configured in tandem via a bus to enable independent execution of operations, instructions, pipelining, and/or multithreading.

In an example embodiment, the processor 202 may be configured to execute instructions stored in the memory 204 or otherwise accessible to the processor. Alternatively, or additionally, the processor 202 may be configured to execute hard-coded functionality. As such, whether configured by hardware or software methods, or by a combination thereof, processor 202 may represent an entity (e.g., physically embodied in circuitry) capable of performing operations according to embodiments of the present disclosure while configured accordingly. Alternatively, or additionally, processor 202 may be embodied as an executor of software instructions, and the instructions may specifically configure the processor 202 to perform the various algorithms embodied in one or more operations described herein when such instructions are executed. In some embodiments, the processor 202 includes hardware, software, firmware, and/or a combination thereof that performs one or more operations described herein.

In some embodiments, the processor 202 (and/or co-processor or any other processing circuitry assisting or otherwise associated with the processor) is/are in communication with the memory 204 via a bus for passing information among components of the apparatus 200.

Memory 204 or memory circuitry 204 may be non-transitory and may include, for example, one or more volatile and/or non-volatile memories. In some embodiments, the memory 204 includes or embodies an electronic storage device (e.g., a computer readable storage medium). In some embodiments, the memory 204 is configured to store information, data, content, applications, instructions, or the like, for enabling an apparatus 200 to carry out various operations and/or functions in accordance with example embodiments of the present disclosure.

Input/output circuitry 206 may be included in the apparatus 200. In some embodiments, input/output circuitry 206 may provide output to the user and/or receive input from a user. The input/output circuitry 206 may be in communication with the processor 202 to provide such functionality. The input/output circuitry 206 may comprise one or more user interface(s). In some embodiments, a user interface may include a display that comprises the interface(s) rendered as a web user interface, an application user interface, a user device, a backend system, or the like. In some embodiments, the input/output circuitry 206 also includes a keyboard, a mouse, a joystick, a touch screen, touch areas, soft keys a microphone, a speaker, or other input/output mechanisms. The processor 202 and/or input/output circuitry 206 comprising the processor may be configured to control one or more operations and/or functions of one or more user interface elements through computer program instructions (e.g., software and/or firmware) stored on a memory accessible to the processor (e.g., memory 204, and/or the like). In some embodiments, the input/output circuitry 206 includes or utilizes a user-facing application to provide input/output functionality to a computing device and/or other display associated with a user.

Communications circuitry 208 may be included in the apparatus 200. The communications circuitry 208 may include any means such as a device or circuitry embodied in either hardware or a combination of hardware and software that is configured to receive and/or transmit data from/to a network and/or any other device, circuitry, or module in communication with the apparatus 200. In some embodiments the communications circuitry 208 includes, for example, a network interface for enabling communications with a wired or wireless communications network. Additionally, or alternatively, the communications circuitry 208 may include one or more network interface card(s), antenna(s), bus(es), switch(es), router(s), modem(s), and supporting hardware, firmware, and/or software, or any other device suitable for enabling communications via one or more communications network(s). In some embodiments, the communications circuitry 208 may include circuitry for interacting with an antenna(s) and/or other hardware or software to cause transmission of signals via the antenna(s) and/or to handle receipt of signals received via the antenna(s). In some embodiments, the communications circuitry 208 enables transmission to and/or receipt of data from a user device, one or more sensors, and/or other external computing device(s) in communication with the apparatus 200.

Data intake circuitry 212 may be included in the apparatus 200. The data intake circuitry 212 may include hardware, software, firmware, and/or a combination thereof, designed and/or configured to capture, receive, request, and/or otherwise gather data associated with initiating performance of one or more primary incident response actions. In some embodiments, the data intake circuitry 212 includes hardware, software, firmware, and/or a combination thereof, that communicates with one or more sensor(s) component(s), and/or the like to receive particular data associated with initiating performance of one or more primary incident response actions. Additionally, or alternatively, in some embodiments, the data intake circuitry 212 includes hardware, software, firmware, and/or a combination thereof, that retrieves particular data associated with initiating performance of one or more primary incident response actions from one or more data repository/repositories accessible to the apparatus 200.

AI and machine learning circuitry 210 may be included in the apparatus 200. The AI and machine learning circuitry 210 may include hardware, software, firmware, and/or a combination thereof designed and/or configured to request, receive, process, generate, and transmit data, data structures, control signals, and electronic information for training and executing a trained AI and machine learning model configured for facilitating the operations and/or functionalities described herein. For example, in some embodiments the AI and machine learning circuitry 210 includes hardware, software, firmware, and/or a combination thereof, that identifies training data and/or utilizes such training data for training a particular machine learning model, AI, and/or other model to generate particular output data based at least in part on learnings from the training data. Additionally, or alternatively, in some embodiments, the AI and machine learning circuitry 210 includes hardware, software, firmware, and/or a combination thereof, that embodies or retrieves a trained machine learning model, AI and/or other specially configured model utilized to process inputted data. Additionally, or alternatively, in some embodiments, the AI and machine learning circuitry 210 includes hardware, software, firmware, and/or a combination thereof that processes received data utilizing one or more algorithm(s), function(s), subroutine(s), and/or the like, in one or more pre-processing and/or subsequent operations that need not utilize a machine learning or AI model.

Data output circuitry 214 may be included in the apparatus 200. The data output circuitry 214 may include hardware, software, firmware, and/or a combination thereof, that configures and/or generates an output based at least in part on data processed by the apparatus 200. In some embodiments, the data output circuitry 214 includes hardware, software, firmware, and/or a combination thereof, that generates a particular report based at least in part on the processed data, for example where the report is generated based at least in part on a particular reporting protocol. Additionally, or alternatively, in some embodiments, the data output circuitry 214 includes hardware, software, firmware, and/or a combination thereof, that configures a particular output data object, output data file, and/or user interface for storing, transmitting, and/or displaying. For example, in some embodiments, the data output circuitry 214 generates and/or specially configures a particular data output for transmission to another system sub-system for further processing. Additionally, or alternatively, in some embodiments, the data output circuitry 214 includes hardware, software, firmware, and/or a combination thereof, that causes rendering of a specially configured user interface based at least in part on data received by and/or processing by the apparatus 200.

In some embodiments, two or more of the sets of circuitries 202-214 are combinable. Alternatively, or additionally, one or more of the sets of circuitry 202-214 perform some or all of the operations and/or functionality described herein as being associated with another circuitry. In some embodiments, two or more of the sets of circuitry 202-214 are combined into a single module embodied in hardware, software, firmware, and/or a combination thereof. For example, in some embodiments, one or more of the sets of circuitry, for example the AI and machine learning circuitry 210, may be combined with the processor 202, such that the processor 202 performs one or more of the operations described herein with respect to the AI and machine learning circuitry 210.

With reference to FIGS. 1-3, in some embodiments, the vehicle incident operational system 300 may be configured to identify vehicle data. In some embodiments, vehicle data may include one or more of vehicle external data, vehicle occupant data, time clock data, and vehicle operations data.

In some embodiments, vehicle external data may be one or more items of data representative of and/or associated with one or more factors external to the vehicle 140. For example, vehicle external data may be representative of weather information, traffic information, information about the asset 102, and/or the like. In some embodiments, vehicle occupant data may be one or more items of data representative of and/or associated with an occupant of the vehicle 140 (e.g., an individual being transported to a hospital after an accident). For example, vehicle occupant data may be representative of an occupant's heart rate (e.g., 72 beats per minute), drugs received by an occupant (e.g., 30mg epinephrine), medical condition of an occupant, and/or the like. As another example, vehicle occupant data may be representative of an occupant's mental state and/or psychological state. Said differently, in some embodiments, vehicle occupant data may be one or more items of data representative of and/or associated with health vitals of an occupant of the vehicle 140. In some embodiments, time clock data may be one or more items of data representative of and/or associated with a time associated with the vehicle 140. For example, time clock data may be representative of the current time at the location of the vehicle 140. In some embodiments, vehicle operations data may be one or more items of data representative of and/or associated with the operations of the vehicle 140. For example, vehicle operations data may be one or more items of data representative of an altitude of the vehicle 140, a heading of the vehicle 140, turbulence experienced by the vehicle 140, remaining flight time of the vehicle 140, and/or the like.

In some embodiments, the vehicle incident operational system 300 may be configured to identify vehicle data from one or more data sources. For example, vehicle external data may be identified from a vehicle external data source 302. As another example, vehicle occupant data may be identified from an occupant data source 304. In some embodiments, the occupant data source 304 may include an imaging device (e.g., a camera) configured to capture images of an occupant to capture vehicle occupant data representative of an occupant's mental state and/or psychological state. As another example, time clock data may be identified from a vehicle time clock data source 305. As another example, vehicle operations data may be identified from a vehicle operations data source 308. In some embodiments, identifying vehicle data may include extracting the vehicle data from one or more apparatuses associated with the vehicle 140. For example, identifying vehicle operations data may include extracting the vehicle operations data from one or more of a vehicle control apparatus 310, a vehicle avionics apparatus 312, and/or a vehicle communications apparatus 314.

In some embodiments, the vehicle incident operational system 300 may be configured to generate optimized vehicle data. In some embodiments, the vehicle incident operational system 300 may be configured to generate optimized vehicle data by applying the vehicle data to a vehicle aggregation and identification model 320. In some embodiments, the vehicle aggregation and identification model 320 may be a data entity that describes parameters, hyper-parameters, and/or defined operations of a rules-based, machine learning model, and/or generative artificial intelligence model (e.g., model including at least one of one or more rule-based layers, one or more layers that depend on trained parameters, coefficients, and/or the like) configured to at least in part generate optimized vehicle data. The vehicle aggregation and identification model 320 may utilize one or more of any type of machine learning, rules-based, and/or artificial intelligence techniques including one or more of supervised learning (e.g., using user feedback), unsupervised learning, semi-supervised learning, reinforcement learning, computer vision techniques, sequence modeling techniques, language processing techniques, neural network techniques, and/or generative artificial intelligence techniques. In some embodiments, the optimized vehicle data may be one or more items of data representative of and/or associated with vehicle data that has been optimized. For example, optimized vehicle data may be representative of vehicle data from various data sources that has been aggregated, identified, and labeled.

In some embodiments, the vehicle aggregation and identification model 320 may be configured to be trained based on historical optimized vehicle data and/or historical vehicle data. In some embodiments, training the vehicle aggregation and identification model 320 may include training the vehicle aggregation and identification model 320 to recognize vehicle data that should not be included in optimized vehicle data (e.g., vehicle data that should not be optimized). For example, training the vehicle aggregation and identification model 320 may include training the vehicle aggregation and identification model 320 to recognize vehicle data that should not be included in optimized vehicle data for legal reasons and/or policy reasons. In some embodiments, training the vehicle aggregation and identification model 320 may include training the vehicle aggregation and identification model 320 to recognize vehicle data that should be included in optimized vehicle data that was not previously included in optimized vehicle data. In some embodiments, training the vehicle aggregation and identification model 320 may include training the vehicle aggregation and identification model 320 to recognize vehicle data that should be modified before being included in optimized vehicle data that was not previously modified before being included in optimized vehicle data.

In some embodiments, the vehicle incident operational system 300 may be configured to identify geolocation and connection data. In some embodiments, identifying geolocation and connection data may include extracting the geolocation and connection data from one or more apparatuses associated with the vehicle 140. For example, identifying geolocation and connection data may include extracting the geolocation and connection data from a geolocation apparatus 316 and/or a connection apparatus 318. In some embodiments, geolocation and connection data may be one or more items of data representative of and/or associated with the geolocation of the vehicle 140. Additionally, or alternatively, geolocation and connection data may be one or more items of data representative of and/or associated with a connection associated with the vehicle 140 (e.g., connection strength, connection type (e.g., cellular), etc.).

In some embodiments, the vehicle incident operational system 300 may be configured to generate vehicle geolocation and connection enablement data. In some embodiments, the vehicle incident operational system 300 may be configured to generate vehicle geolocation and connection enablement data by applying geolocation and connection data to a vehicle geolocation and connection model 322. In some embodiments, the vehicle geolocation and connection model 322 may be a data entity that describes parameters, hyper-parameters, and/or defined operations of a rules-based, machine learning model, and/or generative artificial intelligence model (e.g., model including at least one of one or more rule-based layers, one or more layers that depend on trained parameters, coefficients, and/or the like) configured to at least in part generate vehicle geolocation and connection enablement data. The vehicle geolocation and connection model 322 may utilize one or more of any type of machine learning, rules-based, and/or artificial intelligence techniques including one or more of supervised learning (e.g., using user feedback), unsupervised learning, semi-supervised learning, reinforcement learning, computer vision techniques, sequence modeling techniques, language processing techniques, neural network techniques, and/or generative artificial intelligence techniques. In some embodiments, vehicle geolocation and connection enablement data may be one or more items of data representative of and/or associated with incident response actions that are enabled based on geolocation and connection data associated with the vehicle 140.

In some embodiments, the vehicle incident operational system 300 may be configured to identify unprocessed audio data. In some embodiments, identifying unprocessed audio data may include extracting the unprocessed audio data from one or more apparatuses associated with the vehicle 140. For example, identifying unprocessed audio data may include extracting the unprocessed audio data from the vehicle communications apparatus 314. In some embodiments, unprocessed audio data may be one or more items of data representative of and/or associated with audio in the vehicle 140.

In some embodiments, the vehicle incident operational system 300 may be configured to generate vehicle audio data. In some embodiments, the vehicle incident operational system 300 may be configured to generate vehicle audio data by applying unprocessed audio data to a vehicle audio processing model 326. In some embodiments, the vehicle audio processing model 326 may be a data entity that describes parameters, hyper-parameters, and/or defined operations of a rules-based, machine learning model, and/or generative artificial intelligence model (e.g., model including at least one of one or more rule-based layers, one or more layers that depend on trained parameters, coefficients, and/or the like) configured to at least in part generate vehicle audio data. The vehicle audio processing model 326 may utilize one or more of any type of machine learning, rules-based, and/or artificial intelligence techniques including one or more of supervised learning (e.g., using user feedback), unsupervised learning, semi-supervised learning, reinforcement learning, computer vision techniques, sequence modeling techniques, language processing techniques, neural network techniques, and/or generative artificial intelligence techniques. In some embodiments, vehicle audio data may be one or more items of data representative of and/or associated with unprocessed audio data that has been processed. In this regard, for example, vehicle audio data may be representative of text (e.g., natural language text) representative of unprocessed audio data (e.g., words, phrases, sounds, etc.) associated with the vehicle 140. For example, vehicle audio data may be representative of a transcript of spoken words by one or more individuals of the vehicle 140 (e.g., a transcript that includes the phrase "occupant is experiencing anaphylactic shock").

In some embodiments, applying unprocessed audio data to the vehicle audio processing model 326 includes performing at least one voice analysis task. In this regard, in some embodiments, a voice analysis task includes one or more computing operations that identifies nonlinguistic content associated with the unprocessed audio data. For example, a voice analysis task may include one or more computing operations that identifies an emotional state associated with the unprocessed audio data (e.g., an emotional state of an occupant of the vehicle 140). In some embodiments, applying unprocessed audio data to the vehicle audio processing model 326 includes performing at least one recognition tasks. In some embodiments, a recognition task includes one or more computing operations that identifies linguistic content associated with the unprocessed audio data. For example, a recognition task may include one or more computing operations that include keyword detection, speech recognition (e.g., speech-to-text), voice activity detection (e.g., when occupants of the vehicle 140 are talking and/or when occupants the vehicle 140 are silent), speaker identification or speaker verification (e.g., which occupants of the vehicle 140 are speaking), and/or the like.

In some embodiments, the vehicle incident operational system 300 may be configured to generate a prioritized vehicle data package. Additionally, or alternatively, vehicle incident operational system 300 may be configured to generate a secondary vehicle data package. In some embodiments, vehicle incident operational system 300 may be configured to generate a prioritized vehicle data package and/or a secondary vehicle data package by applying optimized vehicle data, vehicle geolocation and connection enablement data, and/or vehicle audio data to a vehicle prioritization model 324. In some embodiments, the vehicle prioritization model 324 may be a data entity that describes parameters, hyper-parameters, and/or defined operations of a rules-based, machine learning model, and/or generative artificial intelligence model (e.g., model including at least one of one or more rule-based layers, one or more layers that depend on trained parameters, coefficients, and/or the like) configured to at least in part generate a prioritized vehicle data package and/or a secondary vehicle data package. The vehicle prioritization model 324 may utilize one or more of any type of machine learning, rules-based, and/or artificial intelligence techniques including one or more of supervised learning (e.g., using user feedback), unsupervised learning, semi-supervised learning, reinforcement learning, computer vision techniques, sequence modeling techniques, language processing techniques, neural network techniques, and/or generative artificial intelligence techniques.

In some embodiments, the vehicle incident operational system 300 may be configured to initiate performance of one or more primary incident response actions based at least in part on the prioritized vehicle data package. For example, the vehicle incident operational system 300 may be configured to initiate performance of one or more primary incident response actions by transmitting the prioritized vehicle data package to the asset 102. As another example, the vehicle incident operational system 300 may be configured to initiate performance of one or more primary incident response actions by causing one or more forms to be generated, detecting anomalies associated with occupants (e.g., patients) of the vehicle 140 (e.g., including the times these anomalies occur and their relationship to other systems and/or events), and/or the like. In some embodiments, the vehicle incident operational system 300 may be configured to initiate performance of one or more primary incident response actions when the vehicle 140 is in flight (e.g., in real-time).

In some embodiments, the vehicle incident operational system 300 may be configured to initiate performance of one or more primary incident response actions based on an event occurrence. For example, the vehicle incident operational system 300 may be configured to initiate performance of one or more primary incident response actions based on an event occurrence that includes being within a certain distance of the asset 102. In this regard for example, the vehicle incident operational system 300 may be configured to initiate performance of one or more primary incident response actions when the vehicle 140 arrives within 10 miles of the asset 102. As another example, the vehicle incident operational system 300 may be configured to initiate performance of one or more primary incident response actions based on an event occurrence that includes connecting to a communication system associated with the asset 102. In this regard, for example, the vehicle incident operational system 300 may be configured to initiate performance of one or more primary incident response actions when vehicle incident operational system 300 and/or one or more other components of the vehicle 140 (e.g., the vehicle communications apparatus 314) connects to a Wi-Fi network of the asset 102.

Additionally, or alternatively, the vehicle incident operational system 300 may be configured to initiate performance of one or more secondary incident response actions based at least in part on the secondary vehicle data package. For example, the vehicle incident operational system 300 may be configured to initiate performance of one or more secondary incident response actions by transmitting the secondary vehicle data package to the asset 102. In some embodiments, the vehicle incident operational system 300 may be configured to initiate performance of one or more secondary incident response actions when the vehicle 140 is on the ground.

In some embodiments, the vehicle incident operational system 300 may be configured to initiate performance of one or more secondary incident response actions based on an event occurrence. For example, the vehicle incident operational system 300 may be configured to initiate performance of one or more secondary incident response actions based on an event occurrence that includes being within a certain distance of the asset 102. In this regard for example, the vehicle incident operational system 300 may be configured to initiate performance of one or more secondary incident response actions when the vehicle 140 arrives within 1 mile of the asset 102 (e.g., when the vehicle 140 lands at a landing location, such as a helipad, associated with the asset 102). As another example, the vehicle incident operational system 300 may be configured to initiate performance of one or more secondary incident response actions based on an event occurrence that includes connecting to a communication system associated with the asset 102. In this regard, for example, the vehicle incident operational system 300 may be configured to initiate performance of one or more secondary incident response actions when vehicle incident operational system 300 and/or one or more other components of the vehicle 140 (e.g., the vehicle communications apparatus 314) connects to a Wi-Fi network of the asset 102.

### Example Methods

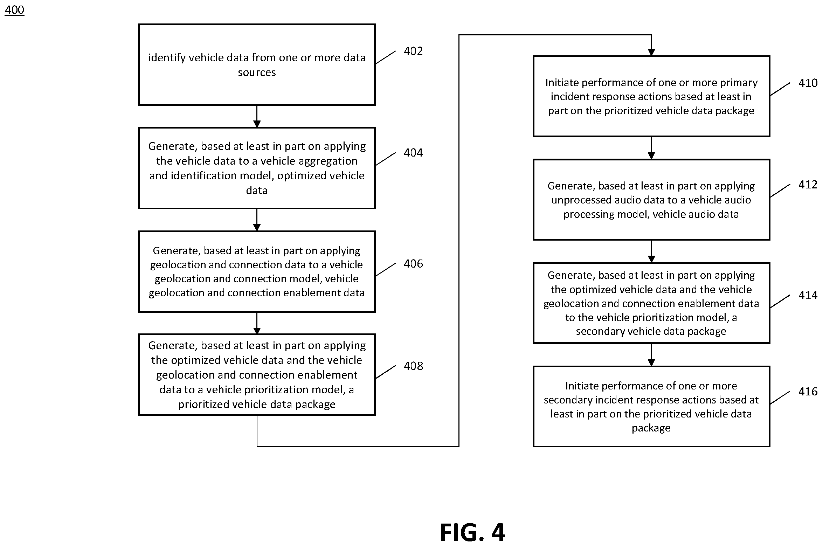

Referring now to FIG. 4, a flowchart providing an example method 400 is illustrated. In this regard, FIG. 4 illustrates operations that may be performed by the vehicle incident operational system 300. In some embodiments, the example method 400 defines a computer-implemented process, which may be executable by any of the device(s) and/or system(s) embodied in hardware, software, firmware, and/or a combination thereof, as described herein. In some embodiments, computer program code including one or more computer-coded instructions are stored to at least one non-transitory computer-readable storage medium, such that execution of the computer program code initiates performance of the method 400.

As shown in block 402, the method 400 may include identifying vehicle data from one or more data sources. As described above, in some embodiments, vehicle data may include one or more of vehicle external data, vehicle occupant data, time clock data, and vehicle operations data.

In some embodiments, vehicle external data may be one or more items of data representative of and/or associated with one or more factors external to the vehicle. For example, vehicle external data may be representative of weather information, traffic information, information about the asset, and/or the like. In some embodiments, vehicle occupant data may be one or more items of data representative of and/or associated with an occupant of the vehicle (e.g., an individual being transported to a hospital after an accident). For example, vehicle occupant data may be representative of an occupant's heart rate (e.g., 72 beats per minute), drugs received by an occupant (e.g., 30 mg epinephrine), medical condition of an occupant, and/or the like. AS another example, vehicle occupant data may be representative of an occupant's mental state and/or psychological state. Said differently, in some embodiments, vehicle occupant data may be one or more items of data representative of and/or associated with health vitals of an occupant of the vehicle. In some embodiments, time clock data may be one or more items of data representative of and/or associated with a time associated with the vehicle. For example, time clock data may be representative of the current time at the location of the vehicle. In some embodiments, vehicle operations data may be one or more items of data representative of and/or associated with the operations of the vehicle. For example, vehicle operations data may be one or more items of data representative of an altitude of the vehicle, a heading of the vehicle, turbulence experienced by the vehicle, remaining flight time of the vehicle, and/or the like.

In some embodiments, the vehicle incident operational system may be configured to identify vehicle data from one or more data sources. For example, vehicle external data may be identified from a vehicle external data source. As another example, vehicle occupant data may be identified from an occupant data source. In some embodiments, the occupant data source may include an imaging device (e.g., a camera) configured to capture images of an occupant to capture vehicle occupant data representative of an occupant's mental state and/or psychological state. As another example, time clock data may be identified from a vehicle time clock data source. As another example, vehicle operations data may be identified from a vehicle operations data source. In some embodiments, identifying vehicle data may include extracting the vehicle data from one or more apparatuses associated with the vehicle. For example, identifying vehicle operations data may include extracting the vehicle operations data from one or more of a vehicle control apparatus, a vehicle avionics apparatus, and/or a vehicle communications apparatus.

As shown in block 404, the method 400 may include generating, based at least in part on applying the vehicle data to a vehicle aggregation and identification model, optimized vehicle data. As described above, in some embodiments, the vehicle aggregation and identification model may be a data entity that describes parameters, hyper-parameters, and/or defined operations of a rules-based, machine learning model, and/or generative artificial intelligence model (e.g., model including at least one of one or more rule-based layers, one or more layers that depend on trained parameters, coefficients, and/or the like) configured to at least in part generate optimized vehicle data. The vehicle aggregation and identification model may utilize one or more of any type of machine learning, rules-based, and/or artificial intelligence techniques including one or more of supervised learning (e.g., using user feedback), unsupervised learning, semi-supervised learning, reinforcement learning, computer vision techniques, sequence modeling techniques, language processing techniques, neural network techniques, and/or generative artificial intelligence techniques. In some embodiments, the optimized vehicle data may be one or more items of data representative of and/or associated with vehicle data that has been optimized. For example, optimized vehicle data may be representative of vehicle data from various data sources that has been aggregated, identified, and labeled.

In some embodiments, the vehicle aggregation and identification model may be configured to be trained based on historical optimized vehicle data and/or historical vehicle data. In some embodiments, training the vehicle aggregation and identification model may include training the vehicle aggregation and identification model to recognize vehicle data that should not be included in optimized vehicle data (e.g., vehicle data that should not be optimized). For example, training the vehicle aggregation and identification model may include training the vehicle aggregation and identification model to recognize vehicle data that should not be included in optimized vehicle data for legal reasons and/or policy reasons. In some embodiments, training the vehicle aggregation and identification model may include training the vehicle aggregation and identification model to recognize vehicle data that should be included in optimized vehicle data that was not previously included in optimized vehicle data. In some embodiments, training the vehicle aggregation and identification model may include training the vehicle aggregation and identification model to recognize vehicle data that should be modified before being included in optimized vehicle data that was not previously modified before being included in optimized vehicle data.

As shown in block 406, the method 400 may include generating, based at least in part on applying geolocation and connection data to a vehicle geolocation and connection model, vehicle geolocation and connection enablement data. As described above, in some embodiments, the vehicle incident operational system may be configured to identify geolocation and connection data. In some embodiments, identifying geolocation and connection data may include extracting the geolocation and connection data from one or more apparatuses associated with the vehicle. For example, identifying geolocation and connection data may include extracting the geolocation and connection data from a geolocation apparatus and/or a connection apparatus. In some embodiments, geolocation and connection data may be one or more items of data representative of and/or associated with the geolocation of the vehicle. Additionally, or alternatively, geolocation and connection data may be one or more items of data representative of and/or associated with a connection associated with the vehicle (e.g., connection strength, connection type (e.g., cellular), etc.).

As shown in block 408, the method 400 may include generating, based at least in part on applying the optimized vehicle data and the vehicle geolocation and connection enablement data to a vehicle prioritization model, a prioritized vehicle data package. As described above, in some embodiments, vehicle incident operational system may be configured to generate a prioritized vehicle data package and/or a secondary vehicle data package by applying optimized vehicle data, vehicle geolocation and connection enablement data, and/or vehicle audio data to a vehicle prioritization model. In some embodiments, the vehicle prioritization model may be a data entity that describes parameters, hyper-parameters, and/or defined operations of a rules-based, machine learning model, and/or generative artificial intelligence model (e.g., model including at least one of one or more rule-based layers, one or more layers that depend on trained parameters, coefficients, and/or the like) configured to at least in part generate a prioritized vehicle data package and/or a secondary vehicle data package. The vehicle prioritization model may utilize one or more of any type of machine learning, rules-based, and/or artificial intelligence techniques including one or more of supervised learning (e.g., using user feedback), unsupervised learning, semi-supervised learning, reinforcement learning, computer vision techniques, sequence modeling techniques, language processing techniques, neural network techniques, and/or generative artificial intelligence techniques.

As shown in block 410, the method 400 may include initiating performance of one or more primary incident response actions based at least in part on the prioritized vehicle data package. As described above, in some embodiments, the vehicle incident operational system may be configured to initiate performance of one or more primary incident response actions by transmitting the prioritized vehicle data package to the asset. As another example, the vehicle incident operational system may be configured to initiate performance of one or more primary incident response actions by causing one or more forms to be generated, detecting anomalies associated with occupants (e.g., patients) of the vehicle (e.g., including the times these anomalies occur and their relationship to other systems and/or events), and/or the like. In some embodiments, the vehicle incident operational system may be configured to initiate performance of one or more primary incident response actions when the vehicle is in flight (e.g., in real-time).

In some embodiments, the vehicle incident operational system may be configured to initiate performance of one or more primary incident response actions based on an event occurrence. For example, the vehicle incident operational system may be configured to initiate performance of one or more primary incident response actions based on an event occurrence that includes being within a certain distance of the asset. In this regard for example, the vehicle incident operational system may be configured to initiate performance of one or more primary incident response actions when the vehicle arrives within 10 miles of the asset. As another example, the vehicle incident operational system may be configured to initiate performance of one or more primary incident response actions based on an event occurrence that includes connecting to a communication system associated with the asset. In this regard, for example, the vehicle incident operational system may be configured to initiate performance of one or more primary incident response actions when vehicle incident operational system and/or one or more other components of the vehicle (e.g., the vehicle communications apparatus) connects to a Wi-Fi network of the asset.

As shown in block 412, the method 400 may include generating, based at least in part on applying unprocessed audio data to a vehicle audio processing model, vehicle audio data. As described above, in some embodiments, the vehicle incident operational system may be configured to identify unprocessed audio data. In some embodiments, identifying unprocessed audio data may include extracting the unprocessed audio data from one or more apparatuses associated with the vehicle. For example, identifying unprocessed audio data may include extracting the unprocessed audio data from the vehicle communications apparatus. In some embodiments, unprocessed audio data may be one or more items of data representative of and/or associated with audio in the vehicle.

In some embodiments, the vehicle incident operational system may be configured to generate vehicle audio data. In some embodiments, the vehicle incident operational system may be configured to generate vehicle audio data by applying unprocessed audio data to a vehicle audio processing model. In some embodiments, the vehicle audio processing model may be a data entity that describes parameters, hyper-parameters, and/or defined operations of a rules-based, machine learning model, and/or generative artificial intelligence model (e.g., model including at least one of one or more rule-based layers, one or more layers that depend on trained parameters, coefficients, and/or the like) configured to at least in part generate vehicle audio data. The vehicle audio processing model may utilize one or more of any type of machine learning, rules-based, and/or artificial intelligence techniques including one or more of supervised learning (e.g., using user feedback), unsupervised learning, semi-supervised learning, reinforcement learning, computer vision techniques, sequence modeling techniques, language processing techniques, neural network techniques, and/or generative artificial intelligence techniques. In some embodiments, vehicle audio data may be one or more items of data representative of and/or associated with unprocessed audio data that has been processed. In this regard, for example, vehicle audio data may be representative of text (e.g., natural language text) representative of unprocessed audio data (e.g., words, phrases, sounds, etc.) associated with the vehicle. For example, vehicle audio data may be representative of a transcript of spoken words by one or more individuals of the vehicle (e.g., a transcript that includes the phrase "occupant is experiencing anaphylactic shock").

In some embodiments, applying unprocessed audio data to the vehicle audio processing model includes performing at least one voice analysis task. In this regard, in some embodiments, a voice analysis task includes one or more computing operations that identifies nonlinguistic content associated with the unprocessed audio data. For example, a voice analysis task may include one or more computing operations that identifies an emotional state associated with the unprocessed audio data (e.g., an emotional state of an occupant of the vehicle). In some embodiments, applying unprocessed audio data to the vehicle audio processing model includes performing at least one recognition tasks. In some embodiments, a recognition task includes one or more computing operations that identifies linguistic content associated with the unprocessed audio data. For example, a recognition task may include one or more computing operations that include keyword detection, speech recognition (e.g., speech-to-text), voice activity detection (e.g., when occupants of the vehicle are talking and/or when occupants the vehicle are silent), speaker identification or speaker verification (e.g., which occupants of the vehicle are speaking), and/or the like.

As shown in block 414, the method 400 may include generating, based at least in part on applying the optimized vehicle data and the vehicle geolocation and connection enablement data to the vehicle prioritization model, a secondary vehicle data package. As described above, in some embodiments, vehicle incident operational system may be configured to generate a prioritized vehicle data package and/or a secondary vehicle data package by applying optimized vehicle data, vehicle geolocation and connection enablement data, and/or vehicle audio data to a vehicle prioritization model. In some embodiments, the vehicle prioritization model may be a data entity that describes parameters, hyper-parameters, and/or defined operations of a rules-based, machine learning model, and/or generative artificial intelligence model (e.g., model including at least one of one or more rule-based layers, one or more layers that depend on trained parameters, coefficients, and/or the like) configured to at least in part generate a prioritized vehicle data package and/or a secondary vehicle data package. The vehicle prioritization model may utilize one or more of any type of machine learning, rules-based, and/or artificial intelligence techniques including one or more of supervised learning (e.g., using user feedback), unsupervised learning, semi-supervised learning, reinforcement learning, computer vision techniques, sequence modeling techniques, language processing techniques, neural network techniques, and/or generative artificial intelligence techniques.

As shown in block 416, the method 400 may include initiating performance of one or more secondary incident response actions based at least in part on the prioritized vehicle data package. As described above, in some embodiments, the vehicle incident operational system may be configured to initiate performance of one or more secondary incident response actions by transmitting the secondary vehicle data package to the asset. In some embodiments, the vehicle incident operational system may be configured to initiate performance of one or more secondary incident response actions when the vehicle is on the ground.

In some embodiments, the vehicle incident operational system may be configured to initiate performance of one or more secondary incident response actions based on an event occurrence. For example, the vehicle incident operational system may be configured to initiate performance of one or more secondary incident response actions based on an event occurrence that includes being within a certain distance of the asset. In this regard for example, the vehicle incident operational system may be configured to initiate performance of one or more secondary incident response actions when the vehicle arrives within 1 mile of the asset (e.g., when the vehicle lands at a landing location, such as a helipad, associated with the asset). As another example, the vehicle incident operational system may be configured to initiate performance of one or more secondary incident response actions based on an event occurrence that includes connecting to a communication system associated with the asset. In this regard, for example, the vehicle incident operational system may be configured to initiate performance of one or more secondary incident response actions when vehicle incident operational system and/or one or more other components of the vehicle (e.g., the vehicle communications apparatus) connects to a Wi-Fi network of the asset.

### Conclusion

Although an example processing system has been described above, implementations of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more modules of computer program instructions, encoded on computer storage medium for execution by, or to control the operation of, information/data processing apparatus. Alternatively, or in addition, the program instructions can be encoded on an artificially-generated propagated signal, e.g., a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (e.g., multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, e.g., an FPGA (field programmable gate array) or an ASIC (application-specific integrated circuit). The apparatus can also include, in addition to hardware, code that creates an execution environment for the computer program in question, e.g., code that constitutes processor firmware, a protocol stack, a repository management system, an operating system, a cross-platform runtime environment, a virtual machine, or a combination of one or more of them. The apparatus and execution environment can realize various different computing model infrastructures, such as web services, distributed computing and grid infrastructures.

A computer-program (also known as a program, software, software application, script, or code) can be written in any form of programming language, including compiled or interpreted languages, declarative or procedural languages, and it can be deployed in any form, including as a stand-alone program or as a module, component, subroutine, object, or other unit suitable for use in a computing environment. A computer program may, but need not, correspond to a file in a file system. A program can be stored in a portion of a file that holds other programs or information/data (e.g., one or more scripts stored in a markup language document), in a single file dedicated to the program in question, or in multiple coordinated files (e.g., files that store one or more modules, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, e.g., magnetic, magneto-optical disks, or optical disks. However, a computer need not have such devices. Devices suitable for storing computer program instructions and information/data include all forms of non-volatile memory, media and memory devices, including by way of example semiconductor memory devices, e.g., EPROM, EEPROM, and flash memory devices; magnetic disks, e.g., internal hard disks or removable disks; magneto-optical disks; and CD-ROM and DVD-ROM disks. The processor and the memory can be supplemented by, or incorporated in, special purpose logic circuitry.

While this specification contains many specific implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable sub combination. Moreover, although features may be described above as acting in certain combinations and even initially claimed as such, one or more features from a claimed combination can in some cases be excised from the combination, and the claimed combination may be directed to a sub combination or variation of a sub combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain implementations, multitasking and parallel processing may be advantageous.

## Claims

1. A method, comprising:
identifying vehicle data from one or more data sources;
generating, based at least in part on applying the vehicle data to a vehicle aggregation and identification model, optimized vehicle data;
generating, based at least in part on applying geolocation and connection data to a vehicle geolocation and connection model, vehicle geolocation and connection enablement data;
generating, based at least in part on applying the optimized vehicle data and the vehicle geolocation and connection enablement data to a vehicle prioritization model, a prioritized vehicle data package; and
initiating performance of one or more primary incident response actions based at least in part on the prioritized vehicle data package.

2. The method of claim 1, wherein the vehicle data comprises vehicle external data, vehicle occupant data, time clock data, and vehicle operations data.

3. The method of claim 1, wherein the one or more data sources comprises a vehicle external data source, an occupant data source, a vehicle time clock data source, and a vehicle operations data source.

4. The method of claim 1, wherein identifying the vehicle data comprises extracting at least a portion of the vehicle data from one or more of a vehicle control apparatus, a vehicle avionics apparatus, or a vehicle communications apparatus.

5. The method of claim 1, further comprising:
generating, based at least in part on applying unprocessed audio data to a vehicle audio processing model, vehicle audio data.

6. The method of claim 5, wherein applying the unprocessed audio data to the vehicle audio processing model comprises performing at least one voice analysis task or at least one recognition task.

7. The method of claim 5, wherein generating the prioritized vehicle data package further comprises applying the vehicle audio data to the vehicle prioritization model.

8. The method of claim 1, further comprising:
generating, based at least in part on applying the optimized vehicle data and the vehicle geolocation and connection enablement data to the vehicle prioritization model, a secondary vehicle data package.

9. The method of claim 8, further comprising:
initiating performance of one or more secondary incident response actions based at least in part on the secondary vehicle data package.

10. The method of claim 9, wherein the one or more primary incident response actions are initiated when a vehicle associated with the prioritized vehicle data package is in flight and the one or more secondary incident response actions are initiated when the vehicle associated with the prioritized vehicle data package is on the ground.

11. An apparatus comprising at least one processor and at least one non-transitory memory comprising program code, wherein the at least one non-transitory memory and the program code are configured to, with the at least one processor, cause the apparatus to at least:
identify vehicle data from one or more data sources;
generate, based at least in part on applying the vehicle data to a vehicle aggregation and identification model, optimized vehicle data;
generate, based at least in part on applying geolocation and connection data to a vehicle geolocation and connection model, vehicle geolocation and connection enablement data;
generate, based at least in part on applying the optimized vehicle data and the vehicle geolocation and connection enablement data to a vehicle prioritization model, a prioritized vehicle data package; and
initiate performance of one or more primary incident response actions based at least in part on the prioritized vehicle data package.

12. The apparatus of claim 11, wherein the vehicle data comprises vehicle external data, vehicle occupant data, time clock data, and vehicle operations data.

13. The apparatus of claim 11, wherein to identify the vehicle data comprises the at least one non-transitory memory and the program code being configured to, with the at least one processor, further cause the apparatus to at least:
extract at least a portion of the vehicle data from one or more of a vehicle control apparatus, a vehicle avionics apparatus, or a vehicle communications apparatus.

14. The apparatus of claim 11, wherein the at least one non-transitory memory and the program code are configured to, with the at least one processor, further cause the apparatus to at least:
generate, based at least in part on applying unprocessed audio data to a vehicle audio processing model, vehicle audio data.

15. A computer program product comprising at least one non-transitory computer-readable storage medium having computer-readable program code portions stored therein, the computer-readable program code portions comprising an executable portion configured to:
identify vehicle data from one or more data sources;
generate, based at least in part on applying the vehicle data to a vehicle aggregation and identification model, optimized vehicle data;
generate, based at least in part on applying geolocation and connection data to a vehicle geolocation and connection model, vehicle geolocation and connection enablement data;
generate, based at least in part on applying the optimized vehicle data and the vehicle geolocation and connection enablement data to a vehicle prioritization model, a prioritized vehicle data package; and
initiate performance of one or more primary incident response actions based at least in part on the prioritized vehicle data package.
